# FASCICULE DE BREVET EUROPEEN

(11) **EP 2 196 951 B1**
(45) Date de publication et mention de la délivrance du brevet: **24.02.2016**
(21) Numéro de dépôt: 09173438.4
(22) Date de dépôt: 19.10.2009
(51) Int. Cl.: G06K 19/077

(54) **Procédé de fabrication de masse de dispositifs éléctroniques portables permettant des communications sans contact**
Verfahren zur Massenproduktion von tragbaren elektronischen Geräten zur kontaktlosen Kommunikation
Method for mass production of portable electronic devices enabling contactless communication

(30) Priorité: 11.12.2008 FR 0858466
(43) Date de publication de la demande: 16.06.2010
(73) Titulaire: Oberthur Technologies, 92300 Levallois-Perret (FR)
(72) Inventeur: Capitaine, Christophe, 35220, CHATEAUBOURG (FR)
(74) Mandataire: Esselin, Sophie

(56) Documents cités:
- WO-A1-2008/011739
- US-A1- 2002 100 810

## Description

L'invention concerne une procédé de fabrication de masse de dispositifs électroniques portables, ou de poche, permettant des communications sans contact avec un système externe. Elle s'applique notamment à la production de masse de cartes à microcircuit comportant un corps de carte, une antenne, et au moins un circuit électroniques connecté à l'antenne, permettant des communications sans contact avec un lecteur. L'invention concerne plus particulièrement un procédé de fabrication sur une même feuille support d'une multitude de circuits d'antenne en technologie filaire.

Les cartes à puce sans contact sont utilisées dans diverses applications, par exemple pour permettre des opérations bancaires, des communications téléphonique, des opérations de télébilletiques, ou autres opérations d'identification. Elles utilisent un couplage électromagnétique à faible distance (typiquement de l'ordre de 10 cm ou moins, par exemple une distance de l'ordre de 20 mm) entre l'électronique de la carte et un appareil récepteur ou lecteur, pour établir une session de communication et échanger des données.

Ces cartes sont bien connues de l'homme du métier. Elles sont généralement conformes aux spécifications des normes IS07816 et ISO 14443, et se répartissent essentiellement en deux catégories :
- celles qui ne permettent que des communications sans contact. On les appelle dans la suite cartes sans contact. Dans ce cas, la carte comprend dans son épaisseur une antenne et au moins un circuit électronique connecté à cette antenne. Généralement l'antenne et le circuit électronique sont formés sur la même couche support.
- celles qui permettent aussi des communications par contact. On les appelle dans la suite cartes duales. Dans ce cas, une circuit électronique est encarté dans la carte avec des plages de contact externe, pour la connexion dans un lecteur, qui affleurent en surface, et des plages de contacts internes sont reliées à l'antenne insérée dans l'épaisseur de la carte.

La fabrication de telles cartes comprend notamment la fabrication d'une couche support d'antenne, et la formation du corps de carte intégrant cette couche support d'antenne, par exemple par lamination d'autres feuilles autour de cette couche support, ou bien par moulage.

Dans le cas des cartes sans contact, un circuit électronique est fixé sur la feuille support d'antenne. Le circuit électronique peut être directement monté sur cette feuille support, par exemple en utilisant une technologie dite "flip chip", ou bien se présenter sous forme d'un module de circuit intégré. Les deux extrémités de l'antenne sont chacune connectées sur un plot de connexion du circuit ou module électronique. Dans le cas de cartes durales, un module à microcircuit est encarté dans la carte, de manière à laisser les plages de contact externe affleurantes en surface de la carte. Le support d'antenne comporte alors deux plages de contact auxquelles sont connectées les deux extrémités d'antenne et l'encartage est réalisé de manière à mettre en contact des plots de connexion du module aux plages de contact du support d'antenne. Ces plots de connexion du module sont eux même raccordés par toute technique connue à des plots du circuit électronique (ou microcircuit) du module.

Dans l'invention, on s'intéresse plus spécialement à l'étape de fabrication de la couche support d'antenne. Elle comprend la préparation d'une feuille support, la formation de l'antenne sur cette feuille support et la connexion de cette antenne à des plages de connexion sur cette feuille support. Ces plages de connexion peuvent être des plots de contact d'un circuit électronique également placé sur la couche support ; ou bien ces plages de connexion sont des plages de contact formées sur la feuille support, qui seront ensuite connectées à des plages de connexion d'un module électronique encarté dans le corps de carte, elles mêmes reliées à des plots de contact d'un microcircuit du module.

Dans la suite de la description, on entend par circuit d'antenne l'ensemble comprenant une antenne et les plages de contact auxquelles les deux extrémités de l'antenne sont connectées, que ces plages soit des plages de contact formées sur la fouille support d'antenne ou les plots de contact d'un microcircuit fixé sur la feuille support d'antenne.

Dans l'invention, on s'intéresse plus particulièrement à un procédé de fabrication utilisant une technologie filaire pour la formation de l'antenne. Cette technologie est bien connue de l'homme du métier. On peut notamment se reporter à la publication US 6 626 364 B2 décrivant en détail une machine permettant la réalisation d'une telle antenne filaire dans un support non conducteur.

On connait de la demande de brevet WO 2008/011739, un procédé de fabrication d'antennes en technologie filaire, sous forme d'un ruban support textile tissé ou tricoté. Dans l'invention on s'intéresse à une autre technique décrite par exemple dans la publication US 6 088 230 qui détaille un procédé de fabrication d' antenne en technologie filaire. Notamment, elle décrit un procédé de fabrication d'un transpondeur, notamment pour carte à microcircuit sans contact, comprenant au moins une puce 16 et une bobine 36, montées sur un même substrat, les deux extrémités de la bobine étant connectées à des plots de connexion de la puce, dans lequel une première extrémité de la bobine est connectée à un premier plot de connexion de la puce, l'enroulement de bobine est formé sur le substrat, l'autre extrémité de la bobine est connectée à un autre plot de connexion de la bobine, et l'enroulement de bobine est fixé au substrat au moins en certains points. La connexion sur les plots de connexion de la puce est par exemple réalisée par thermo-compression et la fixation du fil de bobine sur le substrat est par exemple obtenue par insertion, par ultra-sons. Notamment un procédé de fixation d'un fil d'antenne dans le support et de connexion d'un fil d'antenne sur des plages de connexion est décrit en détail dans le brevet publié US 6 233 818 B1.

Un tel procédé de fabrication d'antenne en technologie filaire est simple à mettre en oeuvre. En particulier, il facilite les croisements de fils par-dessus les boucles d'antenne, le fil utilisé étant gainé d'isolant, et permet l'insertion au moins partielle du fil dans le support, par ultra-sons.

L'invention a pour objet une amélioration du procédé de fabrication des circuits d'antenne, utilisant la technologie filaire.

On rappelle que les cartes à microcircuits utilisent des processus de fabrication continue ou de masse, c'est à dire permettant de réaliser une multitude de cartes dans le même processus.

En particulier, il est habituel de réaliser une multitude de circuits d'antenne sur une même feuille support, d'intégrer cette feuille support dans l'épaisseur d'une plaque formant une multitude de corps de carte. La plaque est ensuite découpée pour obtenir un lot de cartes individuelles. Dans le cas de cartes duales, l'encartage du module peut se faire suivant un procédé d'encartage de masse, avant découpage, ou individuellement, dans chaque corps de carte découpé.

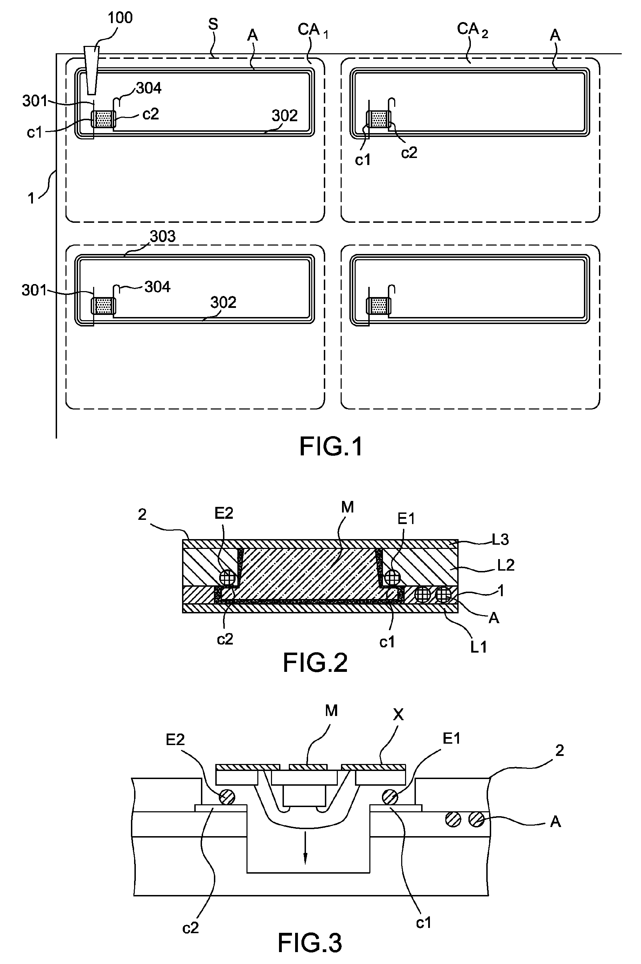

La figure 1 illustre ainsi une vue partielle d'une feuille support 1 d'une pluralité de circuits d'antenne. Chaque circuit CA₁, CA₂, ...etc, comprend une antenne A en technologie filaire dont les deux extrémités sont chacune connectées à une plage de contact c1, c2 respective. Chaque antenne est disposée suivant un tracé déterminé, à l'intérieur d'une surface dématérialisée S qui correspond aux contours du corps de carte, quand il sera découpé.

Dans ce contexte, et comme illustré sur la figure 1, un procédé de fabrication de masse de circuits d'antenne sur une feuille support 1, utilisant un outil 100 de dépose et fixation d'un fil 200 comprend habituellement les étapes suivantes :
a-Positionnement de l'outil 100 en un point 301, correspondant à un point de démarrage d'une antenne A;
b-Enfoncement d'une partie courte du fil 200 dans la feuille support 1, au point 301. Ceci peut se faire typiquement par des moyens ultra-sons, intégrés dans la tête 100. Cette opération dure typiquement de l'ordre de 0,5 seconde par antenne.
c- Déplacement de l'outil pour faire passer le fil au dessus d'une première plage de contact c1, sans soudure. Cette opération dure typiquement de l'ordre de 0,5 seconde par antenne.
d- Déplacement de l'outil suivant un tracé prédéfini pour former l'ensemble des boucles 302 de l'antenne. Cette opération dure typiquement de l'ordre de 3 secondes par antenne.
e- Déplacement de l'outil pour faire passer le fil au dessus de l'autre plage de contact c2, sans soudure. Cette opération dure typiquement de l'ordre de 0,5 seconde par antenne.
f- Enfoncement d'une partie courte du fil en un point 303, par exemple par ultra son, comme à l'étape b.
g- Formation d'une amorce de boucle, permettant la coupe du fil. L'outil de coupe est typiquement intégré à l'outil 200. La coupe n'est généralement possible que lorsque le fil est orienté dans une direction fixe, dans l'exemple illustré, vers le bas. L'opération de formation de l'amorce de boucle dure typiquement 1 seconde par antenne, et l'opération de coupe du fil, de l'ordre de 0,5 seconde par antenne.
h- Déplacement de la tête 100, en position surélevée, sans toucher la feuille 1, c'est-à-dire sans déposer/former l'antenne, vers la position 301 de l'antenne suivante, du circuit d'antenne CA₂. Cette opération dure typiquement 0,5 seconde par antenne.

Le processus se répète ainsi jusqu'à ce que toutes les antennes prévues sur la feuille support soient réalisées.

On notera que les deux étapes b et f d'enfoncement pour chaque antenne, sont deux opérations critiques. En effet, le bout de fil dont on dispose est court. Or il doit être bien enfoncé dans le plastique, pour assurer un bon maintien. C'est pourquoi, cette insertion d'un bout de fil nécessite un certain temps, typiquement de l'ordre de 1 seconde par antenne.

On remarquera aussi, que les contacts c1 et c2 peuvent être déjà présents sur la feuille support, ou bien ils seront réalisés après. Selon les cartes réalisées, le microcircuit avec ces plots de connexion c1, c2, est également fixé sur la feuille support, avant ou après la réalisation de l'antenne. Notamment comme illustré sur la figure 2, dans le cas de cartes sans contact, un module à microcircuit M est fixé sur une feuille support 1 d'une antenne A. Les deux extrémités d'antenne, E1 et E2 sont chacune connectées sur un contact respectif, c1, c2, du module M. La feuille support est insérée dans l'épaisseur de la carte 2, dans l'exemple par une opération de laminage avec d'autres couches L1, L2, L3. Cela peut aussi se faire par moulage. Le module M peut être fixé à l'envers, avec les plots c1, c2 venant par-dessus les extrémités d'antenne (technologie flip-chip). Il est aussi possible de monter un microcircuit directement sur les plages de contact, en technologie flip chip par exemple.

Dans une variante non représentée, le module ou le microcircuit est fixé sur la feuille support en une position déportée des plages de contact c1 et c2 reliées aux extrémités d'antenne. Dans ce cas, la feuille support comporte en outre des pistes de connexion entres les plages de contact c1, c2 et les plots de connexion du module ou d'autres plages de contact connectées au module ou circuit électronique. Ces pistes peuvent être réalisées en technologie filaire, ou par gravure de métal, comme les plages de contact.

Dans le cas d'une carte duale, et comme illustré sur la figure 3, le module M est encarté dans la carte, avec des plages de contact externe X affleurant en surface de la carte. Les plages de contact c1, c2 sont alors typiquement des plages métalliques gravées, sur lesquelles sont soudées les extrémités E1, E2 de l'antenne A.

Dans les deux exemples, l'antenne A est insérée au moins dans la partie des boucles, dans le matériau de la feuille support. Ceci peut se faire de manière connue par une technique à ultra-sons.

Dès lors que les circuits d'antenne sont réalisés, c'est à dire les antennes A et les contacts c1 et c2, avec ou sans microcircuit, le procédé comprend les opérations suivantes :
- connexion des extrémités d'antenne aux plages de contact. Ceci peut se faire typiquement par une opération de thermocompression, dans laquelle au niveau de la plage de contact, le fil se retrouve compressé en même temps qu'amené à une température suffisante permettant de faire fondre la gaine isolante et de souder le coeur métallique à la plage de contact. Cette opération est normalement réalisée en se déplaçant de contact en contact. Dans le cas où les plages de contact ou les plots de connexion sont déjà formés, il n'est pas nécessaire d'avoir réalisé toutes les antennes pour commencer cette opération de connexion des extrémités des antennes déjà réalisées.
- formation d'une plaque de corps de carte 2 intégrant la feuille support 1 dans son épaisseur (figures 2, 3). Cette opération se fait par laminage de la feuille support avec d'autres couches, en matière plastique ou en matière fibreuse, ou par moulage de matériau plastique.
- découpage de la plaque en cartes unitaires, de façon connue par l'homme de métier, typiquement, par poinçonnage (*"punch through"*)*.*

Dans le cas ou le microcircuit est intégré par encartage dans le corps de carte, l'opération d'encartage peut avoir lieu avant le découpage, ou après, de manière individuelle sur chaque carte unitaire.

L'antenne formée par ce procédé peut en outre être au moins en partie insérée dans l'épaisseur de la feuille support, si elle est en plastique, comme illustré sur les figures 2 et 3, typiquement par des moyens ultra-sons intégrés à la tête. En pratique au moins les boucles d'antenne sont ainsi insérées dans l'épaisseur de la feuille support.

Le procédé comprend en outre la vérification de chaque circuit d'antenne connecté à son microcircuit. Si le microcircuit est intégré dans la carte avant l'opération de découpage, cette vérification peut se faire suivant un processus collectif de vérification. Dans ce processus collectif de vérification, la feuille support 1 des circuits d'antenne et microcircuits, ou bien la plaque de corps de carte, avec encartage de modules à microcircuit, est posée sur une machine comportant plusieurs lecteurs, chaque lecteur étant positionné face à une antenne d'un circuit d'antenne, permettant à ce lecteur de communiquer avec le microcircuit correspondant via le circuit d'antenne. L'antenne propre du lecteur est typiquement collée ou très proche du circuit d'antenne testé. Typiquement, la machine se présente comme une table comportant en surface les antennes des lecteurs, positionnées de manière à correspondre aux positions des antennes sur la feuille support ou dans la plaque. La machine teste alors le fonctionnement de chaque microcircuit connecté à son circuit d'antenne.

Typiquement, la machine vérifie pour chaque microcircuit, que lorsqu'un lecteur initialise une communication sans fil à courte portée, ou sans contact, le microcircuit peut répondre, ce qui signifie qu'il est correctement télé-alimenté. On peut en outre vérifier que la réponse sur initialisation ATS (*"Answer To Select"*) retournée par le microcircuit est valide.

Dans le cas des cartes duales avec encartage individuel du module, après découpage de la plaque de corps de carte, la même opération de vérification est effectuée, mais individuellement.

Dans le procédé de fabrication selon l'état de l'art qui vient d'être décrit, les opérations d'insertion de chaque extrémité de fil sont délicates car elles opèrent sur des petits bouts de fil.

En outre, l'opération de coupe entre chaque antenne ralentit la cadence de production.

L'invention a pour objet d'améliorer le procédé de production de masse de cartes à microcircuit sans contact ou duales, qui utilise un procédé de fabrication des antennes en technologie filaire.

L'invention concerne donc un procédé selon la revendication 1.

De préférence, les antennes sont chacune réalisées à l'intérieur d'une surface dématérialisée correspondante sur ledit support, le motif formé par le fil dans chacune desdites surfaces étant identique pour chaque antenne.

L'invention concerne aussi un support de circuits d'antenne, et des dispositifs électroniques portables, notamment des cartes sans contact ou duales, ou des circuits RFID, obtenus selon ce procédé.

L'invention concerne aussi un circuit d'antenne pour communications sans fil, formé en surface d'un support, selon la revendication 13.

D'autres caractéristiques et avantages de l'invention sont détaillés dans la description suivante, et par les dessins illustrant des modes de réalisation de l'invention. Dans ces dessins :
- la figure 1 est une vue d'une feuille support de circuits d'antenne à antennes en technologie filaire selon l'état de l'art;
- la figure 2 est une vue partielle en coupe d'une carte du type sans contact, à antenne en technologie filaire, selon l'état de l'art;
- la figure 3 est une vue partielle en coupe d'une carte du type duale, à antenne en technologie filaire, selon l'état de l'art;
- la figure 4 est une vue d'un support de circuits d'antenne à antennes en technologie filaire selon l'invention;
- la figure 5 illustre un mode de réalisation de l'invention, avec une portion de fil correspondant à la liaison continue entre antennes, réalisée de manière à générer une capacité minimale avec l'antenne;
- la figure 6 illustre un mode de réalisation de l'invention, avec une portion de fil correspondant à la liaison continue entre antennes, réalisée de manière à générer une capacité avec l'antenne, permettant de réduire le nombre de boucles d'antenne;
- la figure 7 est une vue schématique en coupe transversale d'une feuille support avec des antennes formées par un fil en continu selon l'invention, suivant un mode de réalisation de l'invention.

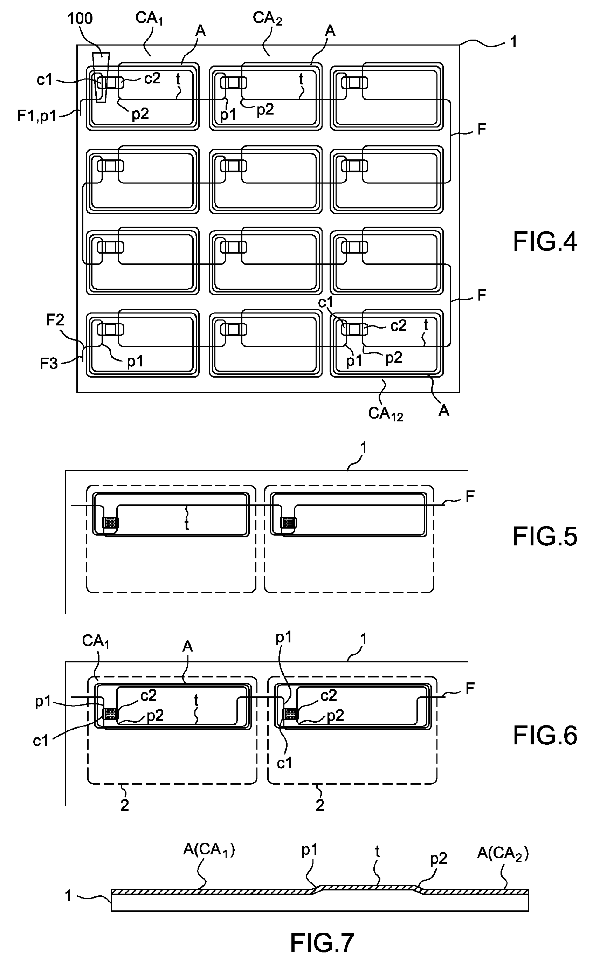

Un procédé de fabrication d'un support 1 d'une pluralité de circuits d'antenne CAᵢ selon l'invention est illustré sur la figure 4, qui montre le support obtenu.

Dans l'exemple, le support est une feuille support, c'est-à-dire un objet mince, adapté par exemple à la fabrication de cartes au format ISO 7816.

Suivant l'invention, les antennes A sur la feuille support sont formées suivant un processus continu de déroulement d'un même fil F, sans coupure.

De manière plus détaillée, un procédé selon l'invention comprend les étapes suivantes :
a1- Positionnement de l'outil 100 en un point F1 de la feuille support 1, correspondant au premier point de fixation p1 de la première antenne à réaliser; enfoncement d'une partie courte du fil F, typiquement par ultra-son;
b1- Déplacement de la tête pour dérouler le fil et le faire passer au dessus d'une première plage de contact c1 (ou de l'emplacement de ce contact si il n'est pas encore réalisé), sans soudure;
c1- Déplacement de la tête pour dérouler le fil et former les boucles de l'antenne ; et enfoncement du fil en au moins certains points ;
d1- Déplacement de la tête pour dérouler le fil et le faire passer au dessus de la deuxième plage de contact c2 (ou son emplacement si il n'est pas encore formé), sans soudure,
e1- Déplacement de la tête, pour dérouler le fil jusqu'au premier point de fixation de l'antenne suivante : c'est la portion référencée t sur la figure 4, entre deux antennes successives.

Les étapes b1 à e1 se répètent jusqu'à arriver au deuxième point de fixation de la dernière antenne réalisée.

De préférence et comme illustré sur la figure 4, l'étape a1 est précédée d'une étape préliminaire dans laquelle l'outil 100 est positionné sur la feuille support, sur un bord, et la tête déplacée pour dérouler le fil jusqu'au premier point de fixation de la première antenne. De cette façon, les antennes réalisées sont toutes identiques.

On remarquera comme illustré sur la figure 4, que le premier point de fixation par lequel on débute la formation d'une antenne peut être p1 ou p2 selon le sens de déplacement de la tête sur la feuille support. Typiquement, les antennes sont en effet agencées matriciellement sur la feuille support, et la tête de l'outil de dépose/formation du fil se déplace par exemple de ligne en ligne comme illustré, en inversant le sens à chaque ligne. Ainsi, dans l'exemple illustré, le deuxième point de fixation de la dernière antenne est le point référencé p1. En ce point on passe à l'étape f1 suivante :
f1- Enfoncement d'une partie courte du fil en un point F2 dans la feuille support, par des moyens, ultra son par exemple, intégrés à la tête 100, et coupe du fil F.

En pratique l'outil de coupe est intégré à la tête 100. La coupe n'est possible que lorsque le fil est orienté dans une direction fixe, par exemple vers le bas, comme illustré sur la figure 4. Pour cela on prévoit à l'étape f1 la formation d'une boucle F3 après le point de fixation F2, qui permet la coupe du fil.

Comme on peut le voir sur la figure, avec un procédé selon l'invention, le fil F est ainsi déroulé en continu depuis le début de la première antenne jusqu'à la fin de la dernière antenne réalisées sur la feuille support 1.

Dans une variante, le fil peut être coupé après avoir réalisé un premier groupe d'antenne. Par exemple, on peut couper le fil à la fin de chaque ligne d'antennes si elles sont réalisées par ligne, ou de chaque colonne d'antennes, si elles sont réalisées par colonne.

Ce procédé permet de gagner un temps de réalisation non négligeable, l'étape d'enfoncement d'un petit bout de fil dans la feuille support n'étant à réaliser que deux fois en tout pour chaque ensemble d'antennes réalisées par déroulement en continu d'un même fil, aux étapes a1 et f1, alors que dans l'état de l'art il fallait le réaliser deux fois pour chaque antenne. Cette étape d'enfoncement étant assez coûteuse en temps, lié à la délicatesse de l'opération, le procédé de fabrication selon l'invention est ainsi avantageux. L'étape h de l'état de l'art précédemment décrite, de déplacement de l'antenne en position haute entre chaque antenne est remplacée par l'étape e1, de sensiblement même durée, typiquement 0,5 seconde par antenne.

En outre, on a pu montrer que la continuité du fil entre les antennes n'empêchait en rien un test collectif de communication, qui consiste à placer la feuille support, ou la plaque de corps de carte dans l'épaisseur de laquelle est insérée la feuille support, sur une table de lecteurs, chaque antenne de la feuille support face à une antenne d'un lecteur correspondant. En effet, le lecteur ne voit que l'antenne locale. Ce test permet de vérifier que l'ensemble comprenant le circuit d'antenne et le module qui y est connecté, est bien capable d'entrer en communication avec le lecteur par couplage électromagnétique.

Dans le cas où le module est placé sur la feuille support comme expliqué précédemment avec la figure 2, on place la feuille support 1 sur une machine avec une table comportant plusieurs lecteurs. La feuille est positionnée en sorte que pour chaque antenne A de la feuille, l'antenne d'un lecteur est collée ou très proche de cette antenne A.

Bien que les antennes A soient toutes connectées entre elles, la machine teste alors le fonctionnement de chaque couple lecteur, module M et circuit d'antenne CAᵢ. Typiquement, la machine vérifie pour chaque module M, que lorsqu'un lecteur initialise la communication avec ce module, alors ce module répond avec une réponse sur initialisation ATS, signifiant que le module est correctement alimenté. La machine peut aussi vérifier que le contenu de la réponse ATS est valide.

Le même test collectif peut être opéré dans le cas d'un module encarté (figure 3), si l'encartage est réalisé collectivement sur une plaque de corps de carte (2) intégrant dans son épaisseur la feuille support 1 obtenue selon l'invention.

Dans tous les cas, le test collectif est réalisé après que les plages de contact aient été formées sur la feuille support, avant ou après les antennes, et le fil d'antenne soudé, en un ou plusieurs points, sur chacune des plages de contact, et que l'antenne soit connectée au microcircuit, soit que les plages de contact sont directement des plots du microcircuit (ou d'un module intégrant le microcircuit), ou que les plages de contact sont connectées à ces plots, soit par des pistes réalisées sur la même feuille support, éventuellement en technologie filaire, dans le cas d'un microcircuit fixé sur la feuille support mais déporté par rapport aux emplacements des plages, c1, c2, ou encore par encartage d'un module.

Ainsi l'invention qui vient d'être décrite permet d'optimiser le procédé de fabrication en masse de cartes à microcircuit sans contact ou duales. Même en ne l'appliquant que par groupes d'antennes de la feuille support, on gagne en temps de fabrication. Il suffit de réaliser au moins deux antennes successives avec le même fil en continu.

Les figures 5 et 6 illustrent deux modes de réalisation de la portion de fil reliant le deuxième point de fixation d'une première antenne au premier point de fixation d'une antenne suivante.

Dans le premier cas illustré sur la figure 5, cette portion est réalisée sensiblement à mi-distance des parties des boucles de la première antenne qui lui sont parallèles. De cette façon la capacité entre cette portion de fil et la première antenne est minimale et n'influe pas la fréquence de résonnance de l'ensemble formé par le circuit d'antenne et le module qui y est connecté.

Dans le deuxième cas illustré sur la figure 6, cette portion t est réalisée sensiblement à proximité des parties des boucles de la première antenne qui lui sont parallèles. De cette façon on crée une boucle passive, avec une capacité entre cette portion de fil et la première antenne, qui entre dans la détermination de la fréquence de résonnance de l'ensemble formé par le circuit d'antenne et le module qui y est connecté. Cette variante permet d'améliorer le facteur de qualité des antennes A, en augmentant la part capacitive devant la part inductive, du circuit résonnant (circuit d'antenne connecté au module).

La figure 7 illustre une autre variante de réalisation de l'invention par laquelle, pour une feuille support plastique, au moins les boucles d'antenne sont insérées au moins partiellement, c'est-à-dire au moins en certains points, dans l'épaisseur de la feuille support, typiquement en utilisant les moyens ultra son intégrés dans la tête de l'outil de formation du fil d'antenne, alors que la portion t reliant deux antennes réalisées successivement sur la feuille est simplement déposée en surface, sans y être fixée/insérée.

L'invention est applicable à la réalisation de tous types de cartes à sans contact ou duales, notamment des cartes au format ID-1 (format d'une carte bancaire), ou des cartes plus petites, tel que par exemple les cartes au format ID-000 (cartes SIM), et des antennes de toutes tailles et motifs de boucles, notamment pour des cartes au format ID-1, des antennes au format ID-1 comme illustré sur la figure 4, ou demi-ID-1 comme illustré sur la figure 1. Elle est aussi applicable à tout format de feuille support, par exemple un format permettant de réaliser 3*8, 6*6, ou 7*8 antennes, et tout diamètre de fil par exemple 80µm, 112µm, 130 µm...ou autre.

Plus généralement, l'invention peut s'appliquer à tout dispositif électronique portable permettant des communications sans fil (sans contact), tel que par exemple les tags RFID.

## Revendications

1. Procédé de fabrication en masse de dispositifs électroniques comprenant une antenne (A) et au moins un microcircuit (M) connecté à ladite antenne, permettant des communications sans fil, le procédé comprenant une étape de fabrication d'une pluralité d'antennes planaires (A) en technologie filaire sur un même support (1), où au moins deux antennes sur ledit support sont formées suivant un processus continu de déroulement d'un même fil (F), sans coupure, **caractérisé en ce que** ce procédé comprend pour une première antenne (A), la fixation du fil (F) dans le support (1) en un premier point (p1), le passage du fil sur l'emplacement d'une première plage de contact (c1) au microcircuit, le déroulement du fil de manière à former une ou plusieurs boucles dans ladite surface, le passage du fil sur l'emplacement d'une deuxième plage de contact (c2) au microcircuit, la fixation du fil dans le support en un deuxième point (p2) après ledit emplacement du deuxième contact, puis le déroulement du fil jusqu'au premier point de fixation d'une antenne suivante sur ledit support.

2. Procédé selon la revendication 1, dans lequel les antennes sont chacune réalisées à l'intérieur d'une surface dématérialisée correspondante (S) sur ledit support (1), le motif formé par le fil (F) dans chacune desdites surfaces étant identique pour chaque antenne.

3. Procédé selon la revendication 1 ou 2, comprenant une étape de formation desdites premières et deuxièmes plages de contact de la pluralité d'antennes sur ledit support, avant ou après la formation de ladite pluralité d'antennes, et une étape de connexion dudit fil sur chacune desdites premières et deuxièmes plages de contact.

4. Procédé de fabrication selon la revendication 3, comprenant une étape de fixation sur ledit support (1) d'une pluralité de microcircuits (M), un par antenne (A), correspondant à la pluralité d'antennes (A), et dans lequel lesdites première et deuxièmes plage de contact de chaque antenne sont reliées à des plots de connexion d'un microcircuit parmi la pluralité de microcircuits.

5. Procédé selon la revendication 1, comprenant
- une étape de fixation sur ledit support, avant ou après la formation de ladite pluralité d'antennes, d'une pluralité de microcircuits (M), un par antenne (A), lesdites premières (c1) et deuxièmes (c2) plages de contact étant des plots de connexion desdits microcircuits et
- une étape de connexion dudit fil sur chacune desdites premières et deuxièmes plages de contact.

6. Procédé selon la revendication 2, dans lequel lesdites plages de contact d'une antenne sont connectées à des plots de connexion d'un microcircuit correspondant dans une étape d'encartage d'un module (M) supportant ledit microcircuit, dans une carte individuelle découpée dans une plaque de corps de carte (2) insérant ledit support (1) dans son épaisseur.

7. Procédé de fabrication selon l'une des revendications 3 à 5, comprenant une étape collective de test de communication sans contact, chaque antenne dudit support étant connectée à un microcircuit, comprenant l'utilisation d'une pluralité de lecteurs sans contact, chaque lecteur positionné en face et à proximité d'une antenne parmi la pluralité d'antennes, pour vérifier l'établissement d'une communication pour chaque antenne avec un lecteur correspondant.

8. Procédé selon l'une quelconque des revendications précédentes, utilisant un support en matière plastique, ou en matière fibreuse.

9. Procédé selon l'une quelconque des revendications 1 à 6, utilisant un support en matière plastique, dans lequel la portion de fil entre le deuxième point de fixation (p2) d'une première antenne et le premier point de fixation (p1) d'une antenne suivante est déposée en surface de ladite feuille support, et la partie du fil correspondant aux boucles d'antenne est inséré au moins en partie dans l'épaisseur du support.

10. Procédé selon l'une quelconque des revendications 1 à 9, dans lequel la portion (t) de fil entre le deuxième point de fixation (p2) d'une première antenne et le premier point de fixation (p1) d'une antenne suivante passe sensiblement à distance des parties des boucles de ladite première antenne qui sont parallèles à ladite portion de fil.

11. Procédé selon l'une quelconque des revendications 1 à 9, dans lequel la portion (t) de fil entre le deuxième point de fixation (p2) d'une première antenne et le premier point de fixation (p1) d'une antenne suivante passe sensiblement à proximité des parties des boucles de ladite première antenne qui sont parallèles à ladite portion de fil, de manière à former une boucle passive.

12. Procédé selon l'une quelconque des revendications précédentes, dans lequel ledit support (1) est inséré dans l'épaisseur d'une plaque de corps de carte (2), ladite plaque étant ultérieurement découpée pour former des cartes individuelles.

13. Circuit d'antenne (CA₁) pour communications sans fil, formé en surface d'un support (S), ledit circuit comprenant une antenne (A) réalisée en technologie filaire et comprenant une ou plusieurs boucles d'un fil (F) entre deux extrémités dudit fil, et deux plages de contact (c1, c2) connectées à l'antenne, **caractérisé en ce que** les deux extrémités dudit fil sont situées sur un bord respectif dudit support, et chacune des connexions aux dites plages de contact est effectuée en un ou plusieurs points du fil situés entre une extrémité respective et lesdites boucles.

14. Circuit d'antenne selon la revendication 13, dans lequel ledit support est en matière fibreuse, ou plastique.

15. Dispositif électronique comportant un circuit d'antenne selon la revendication 13 ou 14.

## Patentansprüche

1. Verfahren zum Massenproduzieren von elektronischen Bauelementen umfassend eine Antenne (A) und wenigstens eine Mikroschaltung (M), die mit der Antenne verbunden ist und drahtlose Kommunikation zulässt, wobei das Verfahren einen Schritt des Produzierens mehrerer planarer Antennen (A) auf demselben Substrat (1) mit drahtgebundener Technologie beinhaltet, wobei wenigstens zwei Antennen auf dem Substrat mit einem kontinuierlichen ununterbrochenen Prozess des Abrollens desselben Drahts (F) gebildet werden, **dadurch gekennzeichnet, dass** das Verfahren für eine erste Antenne (A) Folgendes beinhaltet: Befestigen des Drahts (F) in dem Substrat (1) an einem ersten Punkt (p1), Leiten des Drahts zum Ort eines ersten Kontaktstücks (c1) auf der Mikroschaltung, Abrollen des Drahts so, dass eine oder mehrere Schleifen in der Oberfläche entstehen, Leiten des Drahts zum Ort eines zweiten Kontaktstücks (c2) auf der Mikroschaltung, Befestigen des Drahts in dem Substrat an einem zweiten Punkt (p2) hinter dem Ort des zweiten Kontakts, dann Abrollen des Drahts bis zum ersten Befestigungspunkt einer nachfolgenden Antenne auf dem Substrat.

2. Verfahren nach Anspruch 1, wobei die Antennen jeweils innerhalb einer entsprechenden dematerialisierten Oberfläche (S) auf dem Substrat (1) produziert werden, wobei das von dem Draht (F) in jeder der Oberflächen gebildete Muster für jede Antenne identisch ist.

3. Verfahren nach Anspruch 1 oder 2, das einen Schritt des Bildens der ersten und zweiten Kontaktstücke der mehreren Antennen auf dem Substrat vor oder nach dem Bilden der mehreren Antennen und einen Schritt des Anschließens des Drahts an jedem der ersten und zweiten Kontaktstücke beinhaltet.

4. Produktionsverfahren nach Anspruch 3, das einen Schritt des Befestigens mehrerer Mikroschaltungen (M), einer pro Antenne (A), auf dem Substrat (1) entsprechend den mehreren Antennen (A) beinhaltet, wobei die ersten und zweiten Kontaktstücke jeder Antenne mit Anschlussflächen einer Mikroschaltung aus den mehreren Mikroschaltungen verbunden sind.

5. Verfahren nach Anspruch 1, das Folgendes beinhaltet:
einen Schritt des Befestigens mehrerer Mikroschaltungen (M), einer pro Antenne (A), auf dem Substrat vor oder nach dem Bilden der mehreren Antennen, wobei das erste (e1) und das zweite (c2) Kontaktstück Anschlussflächen der Mikroschaltungen sind; und
einen Schritt des Anschließens des Drahts an jedem der ersten und zweiten Kontaktstücke.

6. Verfahren nach Anspruch 2, bei dem die Kontaktstücke einer Antenne mit Anschlussflächen einer entsprechenden Mikroschaltung in einem Schritt des Verkapselns eines die Mikroschaltung tragenden Moduls (M) in einer aus einer Kartenkörperplatte (2) ausgeschnittenen einzelnen Karte verbunden werden, in deren Dicke das Substrat (1) eingeführt wird.

7. Produktionsverfahren nach einem der Ansprüche 3 bis 5, das einen kollektiven Schritt des kontaktlosen Kommunikationstestens beinhaltet, wobei jede Antenne des Substrats mit einer Mikroschaltung verbunden ist, die die Verwendung mehrerer kontaktloser Leser beinhaltet, wobei jeder Leser gegenüber und nahe einer Antenne der mehreren Antennen positioniert ist, um für jede Antenne mit einem entsprechenden Leser den Kommunikationsaufbau zu prüfen.

8. Verfahren nach einem der vorherigen Ansprüche unter Verwendung eines Substrats aus Kunststoff oder aus Fasermaterial.

9. Verfahren nach einem der Ansprüche 1 bis 6 unter Verwendung eines Substrats aus Kunststoff, wobei der Drahtabschnitt zwischen dem zweiten Befestigungspunkt (p2) einer ersten Antenne und dem ersten Befestigungspunkt (p1) einer nächsten Antenne auf der Oberfläche der Substratfolie abgesetzt wird und der den Antennenschleifen entsprechende Teil des Drahts wenigstens teilweise in die Dicke des Substrats eingeführt wird.

10. Verfahren nach einem der Ansprüche 1 bis 9, wobei der Drahtabschnitt (t) zwischen dem zweiten Befestigungspunkt (p2) einer ersten Antenne und dem ersten Befestigungspunkt (p1) einer nächsten Antenne im Wesentlichen in einem Abstand von Teilen der Schleifen der ersten Antenne passiert, die parallel zu dem Drahtabschnitt sind.

11. Verfahren nach einem der Ansprüche 1 bis 9, wobei der Drahtabschnitt (t) zwischen dem zweiten Befestigungspunkt (p2) einer ersten Antenne und dem ersten Befestigungspunkt (p1) einer nächsten Antenne im Wesentlichen in der Nähe von Teilen der Schleifen der ersten Antenne passiert, die parallel zu dem Drahtabschnitt sind, um eine passive Schleife zu bilden.

12. Verfahren nach einem der vorherigen Ansprüche, wobei das Substrat (1) in die Dicke einer Platte eines Kartenkörpers (2) eingeführt wird, wobei die Platte nachfolgend geschnitten wird, um einzelne Karten zu bilden.

13. Antennenschaltung (CA₁) für drahtlose Kommunikation, gebildet auf der Oberfläche eines Substrats (S), wobei die Schaltung eine mit drahtgebundener Technologie erzeugte Antenne (A) umfasst, die eine oder mehrere Schleifen eines Drahts (F) zwischen zwei Enden des Drahts und zwei mit der Antenne verbundene Kontaktstücke (c1, c2) umfasst, **dadurch gekennzeichnet, dass** sich die zwei Enden des Drahts an einem jeweiligen Rand des Substrats befinden und jede der Verbindungen mit den Kontaktstücken an einem oder mehreren Punkten des Drahts erfolgt, die sich zwischen einem jeweiligen Ende und den Schleifen befinden.

14. Antennenschaltung nach Anspruch 13, wobei das Substrat aus einem Fasermaterial oder Kunststoff besteht.

15. Elektronisches Bauelement, das eine Antennenschaltung nach Anspruch 13 oder 14 umfasst.

## Claims

1. A method for mass-producing electronic devices comprising an antenna (A) and at least one microcircuit (M) connected to said antenna allowing wireless communication, said method comprising a step of producing a plurality of planar antennae (A) on the same support (1) using wired technology, where at least two antennae on said support are formed following a continuous uninterrupted process of dispensing the same wire (F), **characterised in that** said method comprises, for a first antenna (A), fixing said wire (F) in said support (1) at a first point (p1), passing the wire onto the location of a first contact pad (c1) of said microcircuit, dispensing the wire so as to form one or more loops in said surface, passing the wire onto the location of a second contact pad (c2) of said microcircuit, fixing said wire in said support at a second point (p2) downstream of said location of said second contact, then dispensing said wire up to the first fixing point of a subsequent antenna on said support.

2. The method according to claim 1, wherein said antennae are each produced inside a matching dematerialised surface (S) on said support (1), with the pattern formed by said wire (F) in each of said surfaces being identical for each antenna.

3. The method according to claim 1 or 2, comprising a step of forming said first and second contact pads of the plurality of antennae on said support, before or after forming said plurality of antennae, and a step of connecting said wire on each of said first and second contact pads.

4. The production method according to claim 3, comprising a step of fixing a plurality of microcircuits (M), one per antenna (A), on said support (1), corresponding to the plurality of antennae (A), and wherein said first and second contact pads of each antenna are connected to connection blocks of one microcircuit from among the plurality of microcircuits.

5. The method according to claim 1, comprising:
a step of fixing a plurality of microcircuits (M), one per antenna (A), on said support, before or after the formation of said plurality of antennae, said first (el) and second (c2) contact pads being connection blocks of said microcircuits; and
a step of connecting said wire on each of said first and second contact pads.

6. The method according to claim 2, wherein said contact pads of an antenna are connected to connection blocks of a matching microcircuit during a step of encapsulating a module (M) supporting said microcircuit in an individual card cut out of a board of the card body (2), into the thickness of which said support (1) is inserted.

7. The production method according to any one of claims 3 to 5, comprising a collective step of contactless communication testing, each antenna of said support being connected to a microcircuit, comprising the use of a plurality of contactless readers, each reader being positioned opposite and in the vicinity of one antenna from among the plurality of antennae, in order to verify that for each antenna communication has been established with a corresponding reader.

8. The method according to any one of the preceding claims, using a support made of plastic material or of fibre material.

9. The method according to any one of claims 1 to 6, using a support made of plastic material, wherein the wire portion between the second fixing point (p2) of a first antenna and the first fixing point (p1) of a next antenna is deposited onto the surface of said support film, and the section of the wire that corresponds to the antenna loops is at least partly inserted into the thickness of the support.

10. The method according to any one of claims 1 to 9, wherein the portion (t) of wire between said second fixing point (p2) of a first antenna and said first fixing point (p1) of a next antenna substantially passes at a distance from sections of the loops of said first antenna that are parallel to said wire portion.

11. The method according to any one of claims 1 to 9, wherein the portion (t) of wire between said second fixing point (p2) of a first antenna and said first fixing point (p1) of a next antenna substantially passes in the vicinity of sections of the loops of said first antenna that are parallel to said wire portion so as to form a passive loop.

12. The method according to any one of the preceding claims, wherein said support (1) is inserted into the thickness of a board of a card body (2), said board being subsequently cut out in order to form individual cards.

13. An antenna circuit (CA₁) for wireless communications, formed on the surface of a support (S), said circuit comprising an antenna (A) produced using wired technology and comprising one or more loops of a wire (F) between two ends of said wire and two contact pads (c1, c2) connected to said antenna, **characterised in that** the two ends of said wire are located on a respective edge of said support, and each of the connections to said contact pads is realised at one or more points of the wire that are located between a respective end and said loops.

14. The antenna circuit according to claim 13, wherein said support is made of a fibred or plastic material.

15. An electronic device comprising an antenna circuit according to claim 13 or 14.
